Europäisches Patentamt

European Patent Office

Office européen des brevets

(11) Veröffentlichungsnummer: 0 309 714
A2

## (12) EUROPÄISCHE PATENTANMELDUNG

(21) Anmeldenummer: 88113281.5

(22) Anmeldetag: 16.08.88

(51) Int. Cl.⁴ H03B 19/00

(30) Priorität: 29.09.87 DE 3732858

(43) Veröffentlichungstag der Anmeldung:
05.04.89 Patentblatt 89/14

(84) Benannte Vertragsstaaten:
DE FR GB NL

(71) Anmelder: Siemens Aktiengesellschaft Berlin
und München
Wittelsbacherplatz 2
D-8000 München 2(DE)

(72) Erfinder: Schink, Helmut, Dr.
Barlowstrasse 7a
D-8000 München 81(DE)

(54) Frequenzverdoppelnder, verstärkender Oberflächenwellen-Empfänger.

(57) Ein verstärkender Oberflächenwellen-Empfänger für ein Oberflächenwellen-Element aus einem Material, das den Piezoeffekt zeigt und durch lokale Dotierung elektrisch leitfähig gemacht werden kann, bei dem an der Oberseite eines das Oberflächenwellen-Element bildenden isolierenden Substratkörpers (8) aus dem charakterisierten Material ein Dotierungsgebiet ausgebildet ist, das einen leitfähigen Kanal (7) zwischen zumindest zwei einen bestimmten Abstand voneinander aufweisenden Kontaktelektroden (6,6) derart bildet, daß auftretende Piezoladungen in der Lage sind, die Leitfähigkeit eines Kanals zu modulieren. An eine der Kontaktelektroden (6) ist ein Pol einer Spannungsquelle (4) angeschlossen, deren anderer Pol über einen Wechselstromdetektor (5) mit der anderen Kontaktelektrode (6) verbunden ist.

FIG 2

EP 0 309 714 A2

## Frequenzverdoppelnder, verstärkender Oberflächenwellen-Empfänger.

Die vorliegende Erfindung betrifft einen frequenzverdoppelnden, verstärkenden Oberflächenwellen-Empfänger für ein Oberflächenwellen-Element aus einem Material, das den Piezoeffekt und durch lokale Dotierung elektrisch leitfähig gemacht werden kann.

Bei Oberflächenwellen-Bauelementen werden die das Bauelement durchlaufenden Signale über Wandlerstrukturen ausgekoppelt. Diese Wandlerstrukturen bestehen im allgemeinen aus metallischen Bahnen, die auf einem isolierenden Substrat angeordnet sind. Über den Piezoeffekt koppelt die Oberflächenwelle Ladungen in den Körper des Oberflächenwellen-Bauelements ein, die als Signal abgegriffen werden können. Der Energieinhalt dieser Signale ist jedoch relativ klein, so daß das betreffende Signal nach dessen Auskopplung nachverstärkt und an entsprechende weiterverarbeitende elektronische Bauelemente angepaßt werden muß.

Die Erkennung von Oberflächenwellen-Bauelementen erfordert das Detektieren sowohl der Grundwelle mit der Frequenz f als auch der Oberwelle mit der Frequenz 2f. Die Herstellung von Bauelementen, die über eine aktive Unterdrückung oder Anhebung von Oberwellen verfügen, erfordert die monolithische Integration von frequenzverdoppelnden Bauelementen. Die Ansteuerung weiterer Wandlerstrukturen erfordert hohe Signalpegel.

Der vorliegenden Erfindung liegt die Aufgabe zugrunde, einen frequenzverdoppelnden, verstärkenden Empfänger für Oberflächenwellen zu schaffen, mit dessen Hilfe in besonders einfacher Weise eine Oberwelle mit der Frequenz 2f einer Grundwelle mit der Frequenz f erkannt und eine notwendige Verstärkung des das Oberflächenwellen-Bauelement durchlaufenden Signals erreicht werden kann.

Die der vorliegenden Erfindung zugrundeliegende Aufgabe wird durch einen frequenzverdoppelnden, verstärkenden Oberflächenwellen-Empfänger der eingangs genannten Art und gemäß dem Oberbegriff des Patentanspruchs 1 gelöst, der erfindungsgemäß durch die in dem kennzeichnenden Teil des Anspruchs 1 angegebenen Merkmale charakterisiert ist.

Vorteilhafte Weiterbildungen der Erfindung sind durch die in den Unteransprüchen angegebenen Merkmale gekennzeichnet.

Im folgenden wird die vorliegende Erfindung anhand mehrerer Figuren im einzelnen beschrieben.

Fig. 1 zeigt eine schematische Darstellung eines bevorzugten Ausführungsbeispiels des erfindungsgemäßen Oberflächenwellen-Empfängers.

Fig. 2 zeigt ein Diagramm des zeitlichen Verlaufs eines an Kontaktelektroden des Oberflächenwellen-Elements abgegriffenen Stromes sowie der Anregungsspannung.

Bekannte piezoelektrische Wandler bestehen aus einem Substratkörper aus einem isolierenden Material, das den Piezoeffekt zeigt. Auf der Oberfläche dieses Substratkörpers sind in einem vorbestimmten Abstand zwei metallische Kontaktelektroden aufgebracht, die jeweils mit einer Klemme eines Wechselspannungsdetektors verbunden sind. Die Arbeitsweise einer derartigen Anordnung ist beispielsweise in IEEE 1982 ULTRA SONICS SYMPOSIUM, Seiten 456 bis 460, Michael J. Hoskins und Bill J. Hunsinger: "MONOLITHIC GaAs ACOUSTIC CHARGE TRANSPORT DEVICES" beschrieben.

Eine derartige bekannte Anordnung weist den Nachteil auf, daß die Größe der zur Verfügung stehenden Signalspannung an den beiden Kontaktelektroden aufgrund des geringen Energieinhalts der betreffenden Signale klein ist, so daß das Signal nach seiner Auskopplung nachverstärkt und an entsprechende weiterverar beitende Einrichtungen angepaßt werden muß. Dies führt je nach Anwendungsfall gegebenenfalls zu Schwierigkeiten, in jedem Fall aber zu einem verhältnismäßig hohen technischen Aufwand. Außerdem, ist eine Oberwelle der auftretenden Grundschwingung des Oberflächenwellenelements nicht erfaßbar.

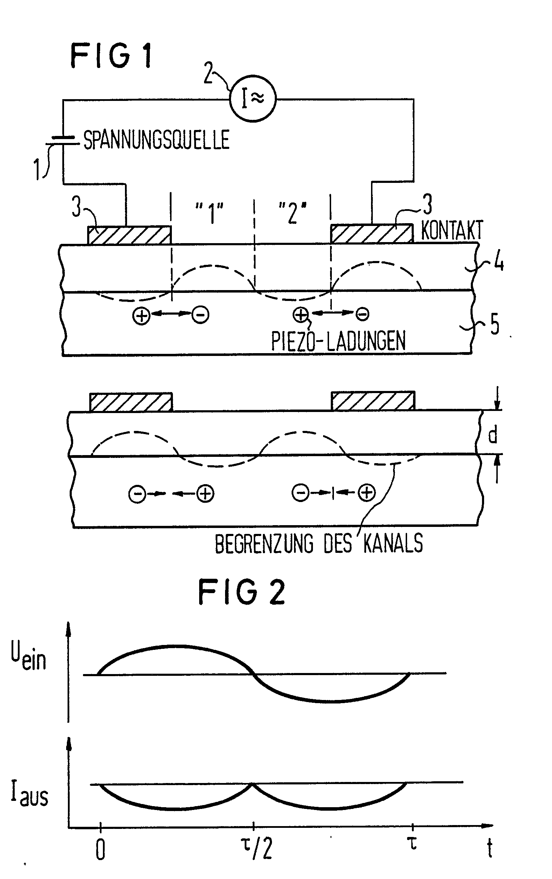

Fig. 1 zeigt, wie bereits erläutert, eine schematische Darstellung eines bevorzugten Ausführungsbeispiels für die vorliegende Erfindung.

Die Darstellung zeigt einen frequenzverdoppelnden, verstärkenden Oberflächenwellen-Empfänger für ein Oberflächenwellen-Element aus einem Material, das den Piezoeffekt zeigt und durch lokale Dotierung elektrisch leitfähig gemacht werden kann. An der Oberseite eines das Oberflächenwellen-Element bildenden isolierenden Substratkörpers 5 aus dem zuvor charakterisierten Material ist ein Dotierungsgebiet ausgebildet, das einen leitfähigen Kanal 4 zwischen zwei einen bestimmten Abstand voneinander aufweisenden Kontaktelektroden 3, 3 derart bildet, daß auftretende Piezoladungen in der Lage sind, die Leitfähigkeit dieses Kanals 4 zu modulieren. An eine der Kontaktelektroden 3 ist ein Pol einer Spannungsquelle 1 angeschlossen, deren anderer Pol über einen Wechselstromdetektor 2 mit der anderen Kontaktelektrode 3 verbunden ist. Der Abstand D zwischen den Kontaktelektroden 3, 3 ist derart festgelegt, daß die Bedingung D ≧ λ erfüllt ist, wobei die Wellenlänge der auftretenden Oberflächenwelle ist, was bedeutet, daß der Abstand D so groß ist, daß zumindest eine vollständige Welle zwischen den Kontaktelektroden Platz findet. Vorzugsweise ist das charakterisierte Material GaAs. Die Spannungsquelle 1 ist vorzugsweise eine Gleichspannungsquelle, kann jedoch alternativ dazu auch eine Wechselspannungsquelle sein, deren Frequenz in einem vorgegebenen Verhältnis zu der Frequenz der Oberflächenwellen steht. Vorzugsweise bestehen die Kontaktelektroden 3, 3 aus einem metallischen Material, beispielsweise Aluminium. Der Wechselstromdetektor 2 kann in verschiedener Art und Weise ausgebildet sein. Vorzugsweise ist er als eine stromdetek tierende Halbleiteranordnung ausgebildet, die als integraler Bestandteil des Oberflächenwellen-Elements auf dem Substratkörper 8 aufgebracht ist.

In die Darstellung gemäß Figur 1 ist schematisch in gestrichelten Linien die Veränderung der Tiefe d des leitfähigen Kanals aufgrund der Steuerwirkung der auftretenden piezoelektrischen Ladungen eingetragen. Durch diese Veränderung oder Modulation des leitfähigen Kanals wird dessen Widerstand verändert, so daß sich in dem durch die Anordnung insgesamt gebildeten Stromkreis der Strom je nach Höhe der Spannung der Spannungsquelle 1 als welliger Gleichstrom oder als Wechselstrom darstellt, wobei dieser wellige Gleichstrom oder Wechselstrom in bekannter Weise durch den Wechselstromdetektor 2 erfaßt werden kann. Die Piezoladungen wirken ähnlich wie bei einem MESFET oder MOSFET die Gate-Ladungen. Die Verstärkungseigenschaften hängen dabei sowohl von der geometrischen als auch von der elektrischen Dimensionierung ab.

Die Frequenzverdopplung wird durch die geeignete Dimensionierung des Elektrodenabstands erreicht. In Fig. 1 ist D = λ angenommen. Ferner sind die Kontaktelektroden so plaziert, daß bei einer stehenden Welle die inneren Kanten der Kontaktelektroden an Schwingungsknoten liegen. Der zeitliche Verlauf des Stromflusses ist in Fig. 2 zusammen mit dem Spannungsverlauf an den die Welle anregenden Elektroden gezeigt. Zum Zeitpunkt 0 ist die Leitfähigkeit des Kanals nicht moduliert gegenüber dessen Gleichgewichtszustand. Zum Zeitpunkt τ/4 schnüren die Piezoladungen den in Fig. 1 mit "1" bezeichneten Teil des Kanals ab. Der Teil "2" wird gleichzeitig aufgesteuert. Liegt an den Kontakten eine so hohe Spannung an, daß die Elektronen im Bereich "1" ihre Sättigungsgeschwindigkeit erreichen, so wird der Stromfluß allein durch den abgeschnürten Teil des Kanals bestimmt. Zum Zeitpunkt τ/2 fließt wieder der Ruhestrom. Der Zeitpunkt 3τ/4 ist identisch mit dem Zeitpunkt τ/4, die Abschnürung des Kanals erfolgt jetzt jedoch in Teil "2". Der zwischen den Kontakten fließende Strom hat also die doppelte Frequenz wie die anregende Welle.

Das erfindungsgemäße Oberflächenwellenbauelement läßt sich auf allen Substrat-Materialien realisieren, die zum einen den Piezoeffekt zeigen und zum anderen durch lokale Dotierung elektrisch leitfähig gemacht werden können. Ein vorzugsweise zu verwendendes Material ist hierbei, wie bereits erwähnt, GaAs.

Die vorliegende Erfindung ist nicht auf das gezeigte Ausführungsbeispiel beschränkt. Modifikationen dieses Ausführungsbeispiels können durch den Fachmann ausgeführt werden, ohne daß dazu der allgemeine Erfindungsgedanke oder der Schutzumfang, wie er durch die Ansprüche bestimmt ist, verlassen werden müßte.

## Ansprüche

1. Frequenzverdoppelnder, verstärkender Oberflächenwellen- Empfänger für ein Oberflächenwellen-Element aus einem Material, das den Piezoeffekt zeigt und durch lokale Dotierung oder durch Aufbringung einer leitenden Schicht elektrisch leitfähig gemacht werden kann, dadurch **gekennzeichnet,** daß an der Oberseite eines das Oberflächenwellen-Element bildenden isolierenden Substratkörpers (5) aus dem charakterisierten Material ein Gebiet ausgebildet ist, das einen leitfähigen Kanal (4) zwischen zwei Kontaktelektroden (3,3) derart bildet, daß auftretende Piezoladungen in der Lage sind, die Leitfähigkeit dieses Kanals (4) zu modulieren, daß der Abstand D zwischen den Kontaktelektroden (3,3) so groß ist, daß zumindest eine vollständige Oberflächenwelle der Länge zwischen diesen Platz findet, d. h. daß die Bedingung

D ≧ λ

erfüllt ist, und daß an eine der Kontaktelektroden (3) ein Pol einer Spannungsquelle (1) angeschlossen ist, deren anderer Pol über einen Wechselstromdetektor (2) mit der anderen Kontaktelektrode (3) verbunden ist.

2. Oberflächenwellen-Empfänger nach Anspruch 1, dadurch **gekennzeichnet,** daß das charakterisierte Material GaAs ist.

3. Oberflächenwellen-Empfänger nach Anspruch 1 oder 2, dadurch **gekennzeichnet,** daß die Kontaktelektroden (3,3) aus einem metallischen Material bestehen.

4. Oberflächenwellen-Empfänger nach Anspruch 1 oder 2,dadurch **gekennzeichnet,**daß die Spannungsquelle (1) eine Gleichspannungsquelle ist.

5. Oberflächenwellen-Empfänger nach Anspruch 1 oder 2, dadurch **gekennzeichnet,** daß die Spannungsquelle (1) eine Wechselspannungsquelle ist, deren Frequenz in einem vorgegebenen Verhältnis zu der Frequenz der Oberflächenwellen steht.

6. Verstärkender Oberflächenwellen-Empfänger nach Anspruch 1 oder 2, dadurch **gekennzeichnet,** daß der Wechselstromdetektor (2) eine stromdetektierende Halbleiteranordnung ist, die als integraler Bestandteil des Oberflächenwellen-Elements auf den Substratkörper (5) aufgebracht ist.

EP 0 309 714 A2

## FIG 1

SPANNUNGSQUELLE

KONTAKT

PIEZO-LADUNGEN

BEGRENZUNG DES KANALS

## FIG 2